# EUROPEAN PATENT APPLICATION

(11) **EP 4 604 705 A1**
(43) Date of publication of application: **20.08.2025**
(21) Application number: 23923417.2
(22) Date of filing: 24.02.2023
(51) Int. Cl.: H10K 71/00

(54) **PRECURSOR, PEROVSKITE LIGHT-ABSORBING LAYER AND PREPARATION METHOD THEREFOR, PEROVSKITE CELL AND ELECTRIC DEVICE**

(71) Applicant: Contemporary Amperex Future Energy Research Institute (Shanghai) Limited, Shanghai 201100 (CN); Contemporary Amperex Technology Co., Limited, Ningde, Fujian 352100 (CN); Shanghai Jiao Tong University, Shanghai 200240 (CN)
(72) Inventor: CHEN, Junchao, Shanghai 201100 (CN); ZHENG, Yiting, Shanghai 201100 (CN); CHEN, Chen, Shanghai 201100 (CN); CHEN, Guodong, Shanghai 201100 (CN); GUO, Yongsheng, Shanghai 201100 (CN)
(74) Representative: Kraus & Lederer PartGmbB
(86) International application number: PCT/CN2023/078196
(87) International publication number: WO 2024/174241

(57) **Abstract**

Embodiments of this application provide a precursor, a perovskite light-absorbing layer and preparation method thereof, a solar cell, and an electric device. The precursor is used for preparing a perovskite light-absorbing layer including a mixed halide perovskite precursor solution and an organic additive added to the mixed halide perovskite precursor solution. In this application, with the addition of the organic additive including a sulfonyl group to the mixed halide perovskite precursor solution, the crystallization kinetics of the mixed halide perovskite in the film formation process is controlled to hinder the mixed halide components from longitudinal gradient phase separation, achieving uniform distribution of halogen components and suppressing the open-circuit voltage loss; and/or suppressing photoinduced phase separation of the mixed halide perovskite after illumination and extending the service life of the wide-bandgap perovskite cell.

## Description

### TECHNICAL FIELD

This application relates to the field of battery technologies, and in particular, to a precursor, a perovskite light-absorbing layer and a preparation method thereof, a perovskite cell, and an electric device.

### BACKGROUND

Halide perovskite cells refer to perovskite cells that use halide-containing perovskite materials as light-absorbing layer materials. Halide-containing perovskite materials exhibit many advantages such as excellent optical absorption coefficient, luminescence quantum efficiency, high tolerance to defects, long-range charge transport, and low-cost manufacturing process, making halide perovskite cells highly attractive and with great application potential.

### SUMMARY

The main technical problems solved in this application are the existence of intrinsic uncertainties in mixed halide perovskite materials and the susceptibility to photoinduced phase separation effects under illumination.

According to a first aspect, a precursor for preparing a perovskite light-absorbing layer includes:
a mixed halide perovskite precursor solution and an organic additive added to the mixed halide perovskite precursor solution; where the organic additive includes a sulfonyl group.

In one or more embodiments of this application, a precursor including the mixed halide perovskite precursor solution and the organic additive is provided, where the organic additive includes a sulfonyl group. Under the condition of preparing a perovskite light-absorbing layer, the crystallization kinetics of mixed halide perovskites in the film formation process is controlled to hinder the mixed halide components from longitudinal gradient phase separation, increasing distribution uniformity of halogen components and reducing the open-circuit voltage loss; and/or reducing photoinduced phase separation of the mixed halide perovskites after illumination and extending the service life of the wide-bandgap perovskite cell.

Specifically, in the organic addition provided in one or more embodiments of this application and including a sulfonyl group, the functional group linked to the sulfonyl group is adjusted so that the organic additive strongly interacts with the halide components in the mixed halide perovskite precursor solution, forming pre-nucleation micelles. This reduces the number of nucleation sites, accelerates nucleation rate, and decreases the crystal growth rate, improving the phase uniformity of the formed perovskite light-absorbing layer, alleviating problems such as intrinsic defects and photoinduced phase separation of the formed perovskite light-absorbing layer, and enhancing the photoelectric conversion efficiency and/or stability of the perovskite cell.

In some embodiments, the organic additive further includes an electron-donating group linked to the sulfonyl group.

In one or more embodiments of this application, an electron-donating group is linked to the sulfonyl group. For positive electrical defects in the mixed halide perovskite precursor solution, an organic additive of an electron donor type is introduced to passivate the positive electrical defects in the mixed halide perovskite precursor solution.

In some embodiments, the electron-donating group includes at least one of -F, 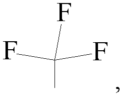 -Cl, -O,

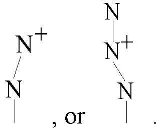

In one or more embodiments of this application, some specific electron-donating groups are provided. When an organic additive containing these groups is added to the mixed halide perovskite precursor solution, the additive strongly interacts with the mixed halide components, showing a good defect passivation effect.

In some embodiments, the sulfonyl group includes at least one of a nitrogen-containing heterocycle, a benzene ring, a carbon chain, or a nitrogen-containing carbon chain.

In one or more embodiments of this application, with the use of an organic additive including at least one of a nitrogen-containing heterocycle, a benzene ring, a carbon chain, or a nitrogen-containing carbon chain, the molecular volume of the organic additive is increased. When the additive strongly interacts with the mixed halide components in the mixed halide perovskite precursor solution, it is conducive to guiding the growth orientation of the perovskite in certain directions, thereby improving the crystallization quality of the perovskite growth and reducing the occurrence of defects.

In some embodiments, the nitrogen-containing heterocycle includes at least one of a nitrogen-containing six-membered heterocycle or a nitrogen-containing five-membered heterocycle.

In one or more embodiments of this application, with the provision of an organic additive including at least one of a nitrogen-containing six-membered heterocycle or a nitrogen-containing five-membered heterocycle, an organic amine-type organic additive is provided. The organic amine strongly interacts with the mixed halide components in the mixed halide perovskite precursor solution, inducing nucleation and growth of iodine-rich phase components, slowing down the crystallization process, and suppressing the formation of grain boundary defects.

In some embodiments, the nitrogen-containing heterocycle includes at least one of

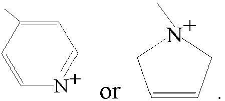

In one or more embodiments of this application, a specific nitrogen-containing heterocycle is provided. In the nitrogen-containing heterocycle, a nitrogen ion is located at the para position relative to a sulfonyl group (-SO₂-) and/or a sulfonyl group (-SO₂-) is linked to a nitrogen ion.

In some embodiments, the carbon chain includes no more than 3 carbon atoms.

In one or more embodiments of this application, a specific carbon chain length is provided. Within this range of carbon chain length, organic additives containing carbon chains can achieve the effect of improving the crystallization quality of perovskite.

In some embodiments, the nitrogen-containing carbon chain includes at least one of

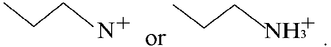

In one or more embodiments of this application, with the provision of a chain-like organic amine-type additive, the improvement on the crystallization quality of perovskite is achieved.

In some embodiments, the organic additive includes at least one of

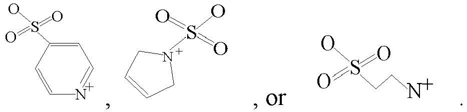

In one or more embodiments of this application, the functional group linked to the sulfonyl group is adjusted to provide an organic additive containing large volume organic amine cations. This additive coordinates with iodine-rich phase components in the halide components during the preparation of the perovskite light-absorbing layer, inducing nucleation and growth of the iodine-rich phase components, slowing down the crystallization process, suppressing the formation of grain boundary defects, and improving the photoelectric conversion efficiency of the perovskite cell.

In some embodiments, the organic additive includes at least one of 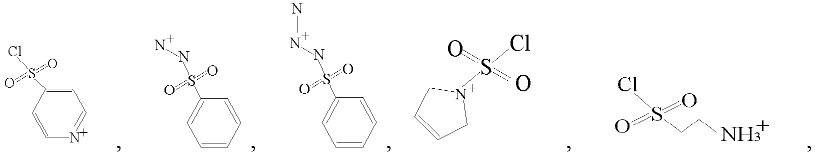 or

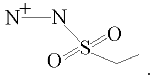

In one or more embodiments of this application, the functional group linked to the sulfonyl group is adjusted so that the organic additive containing the functional groups coordinate with iodine-rich phase components in the halide components during the preparation of the perovskite light-absorbing layer, inducing nucleation and growth of iodine-rich phase components, slowing down the crystallization process, and suppressing the formation of grain boundary defects. This can suppress the initial photoinduced phase separation of mixed halides to enhance the stability and photoelectric conversion efficiency of the perovskite cell. In one or more embodiments of this application, the formed perovskite light-absorbing layer tends to undergo local component separation after illumination, resulting in reduced stability of the perovskite cell.

In some embodiments, the organic additive includes at least one of 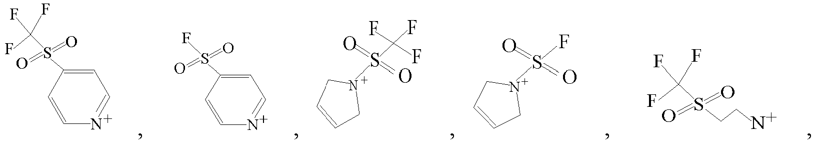 or

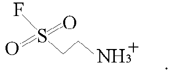

In one or more embodiments of this application, the functional group linked to the sulfonyl group is adjusted so that the organic additives containing the functional group can strongly interact with halide components during the preparation of the perovskite light-absorbing layer, forming pre-nucleation micelles. This reduces nucleation sites, accelerates nucleation, and decreases crystal growth rate, hindering longitudinal gradient phase separation of halide components to enhance the phase uniformity of the formed perovskite light-absorbing layer, thereby reducing intrinsic defects of mixed halide perovskites and suppressing photoinduced phase separation effects in the perovskite light-absorbing layer of the perovskite cell to enhance the photoelectric conversion efficiency and stability of the perovskite cell and cause no local component separation after illumination, further improving the stability of the perovskite cell.

In some embodiments, a molar amount of the organic additive is 0.1%-10% of a molar amount of the mixed halide perovskite precursor solution.

In one or more embodiments of this application, any proportion of the molar amount of the organic additive that can improve the quality of the formed perovskite light-absorbing layer to the molar amount of the mixed halide perovskite precursor solution is within the protection scope of this application. In one or more embodiments, the molar amount of the organic additive is within the range of 0.1%-10% of the molar amount of the mixed halide perovskite precursor solution, and the quality of the formed perovskite light-absorbing layer is high, effectively hindering interface reactions such as redox between the formed perovskite light-absorbing layer and the carrier transport layer, thereby enhancing the performance of the corresponding perovskite cell.

In some embodiments, the material of the perovskite light-absorbing layer includes Cs_{(0-0.05)}FA_{(0.8-0.95)}MA_{(0-0.10)}PbI_{(2.0.2.7)}Br_{(03-1.0)}.

In one or more embodiments of this application, the provided organic additive is added to the precursor solution of the mixed halide perovskite material so that the organic additive coordinates with the iodine-rich phase components therein, inducing nucleation and growth of iodine-rich phase components, slowing down the crystallization process, suppressing grain boundary defects to enhance the photoelectric conversion efficiency of the perovskite cell, and/or suppressing the initial photoinduced phase separation of mixed halides to enhance the stability of the perovskite cell and/or cause no local component separation after illumination, further improving the stability of the perovskite cell.

According to a second aspect, this application provides a perovskite light-absorbing layer, prepared from any precursor according to the first aspect.

In one or more embodiments of this application, the precursor according to the first aspect is used to prepare a perovskite light-absorbing layer with improved photoelectric conversion efficiency and stability, thereby improving the service life and application prospects of the perovskite cell containing the same.

According to a third aspect, this application provides a preparation method of perovskite light-absorbing layer, including: applying the precursor according to the first aspect to the surface of a buried interface, and performing an annealing treatment on a resulting product to form a perovskite light-absorbing layer.

In one or more embodiments of this application, a preparation method of perovskite light-absorbing layer is provided to form a perovskite light-absorbing layer with good quality and stability from any precursor according to the first aspect.

According to a fourth aspect, this application provides a perovskite cell, including a perovskite light-absorbing layer; where the perovskite light-absorbing layer includes the perovskite light-absorbing layer according to the second aspect or a perovskite light-absorbing layer prepared by using the method according to the third aspect.

In one or more embodiments of this application, the provision of a perovskite cell including the perovskite light-absorbing layer according to the second aspect or a perovskite light-absorbing layer prepared by using the method according to the third aspect is conducive to enhancing the photoelectric conversion efficiency of the perovskite cell, and/or suppressing the initial photoinduced phase separation of mixed halides to enhance the stability of the perovskite cell and/or cause no local component separation after illumination, further improving the stability of the perovskite cell.

In some embodiments, the perovskite cell includes a conductive substrate, a first transport layer, the perovskite light-absorbing layer, a second transport layer, and a metal electrode stacked in sequence; where one of the first transport layer and the second transport layer is a hole transport layer, and the other is an electron transport layer.

In one or more embodiments of this application, the provided perovskite cell is suitable for both p-type devices and n-type devices.

In some embodiments, the hole transport layer includes at least one of CuSCN, NiOx, CuI, MoOx, WO₃, ZnO, TiO₂, SnO₂, poly(3,4-ethylenedioxythiophene), polystyrene sulfonate, poly[bis(4-phenyl)(2,4,6-trimethylphenyl)amine], 2,2',7,7'-tetrakis[N,N-di(4-methoxyphenyl)amino]-9,9'-spirobifluorene, polyethoxyethyleneimine, polyethyleneimine, or [6,6]-phenyl-C₆₁-butyric acid methyl ester.

In some embodiments, the electron transport layer includes at least one of CuSCN, NiOx, CuI, MoOx, WO₃, ZnO, TiO₂, SnO₂, poly(3,4-ethylenedioxythiophene), polystyrene sulfonate, polytriarylamine, 2,2',7,7'-tetrakis[N,N-di(4-methoxyphenyl)amino]-9,9'-spirobifluorene, polyethoxyethyleneimine, polyethyleneimine, [6,6]-phenyl-C₆₁-butyric acid methyl ester, fullerenes, or a hole blocking material.

In one or more embodiments of this application, the provision of specific materials for the hole transport layer and the electron transport layer enhances the photoelectric conversion efficiency and stability of the perovskite cell.

According to a fifth aspect, this application provides an electric device, including any perovskite cell according to the fourth aspect.

In one or more embodiments of this application, the perovskite cell serves as a power source to supply power to the electric device, or the perovskite cell can be used as an energy storage unit for the electric device. For example, the electric device may be a lighting element, a display element, an automobile, or the like.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and a person of ordinary skill in the art may still derive other drawings from the accompanying drawings without creative efforts.
FIG. 1 is a schematic diagram of a first structure of a perovskite cell according to this application;
FIG. 2 is a schematic diagram of a second structure of a perovskite cell according to this application; and
FIG. 3 is a schematic diagram of a third structure of a perovskite cell according to this application.

In the accompanying drawings, the figures are not necessarily drawn to scale.

Reference signs are described as follows:
100. perovskite cell, 10. conductive substrate, 20. first transport layer, 30. perovskite light-absorbing layer, 40. second transport layer, 50. metal electrode, HTL. hole transport layer, and ETL. electron transport layer.

### DETAILED DESCRIPTION

The following further describes implementations of this application in detail with reference to accompanying drawings and embodiments. The following detailed description of embodiments and the accompanying drawings are intended to illustrate the principle of this application rather than to limit the scope of this application, that is, this application is not limited to the embodiments as described.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not strictly perpendicular, but within an allowable range of error. "Parallel" is not parallel in the strict sense but within an allowable range of error.

The orientation terms appearing in the following description all are directions shown in the figures, and do not limit the specific structure of the application. In the description of this application, it should also be noted that unless otherwise specified and defined explicitly, the terms "mounting", "connection", and "join" should be understood in their general senses. For example, they may refer to a fixed connection, a detachable connection, or an integral connection, and may refer to a direct connection or an indirect connection via an intermediate medium. Persons of ordinary skill in the art can understand specific meanings of these terms in this application as appropriate to specific situations.

Due to the existence of intrinsic uncertainties, halide perovskites are susceptible to external factors, directly impacting the photoelectric conversion efficiency and stability of the halide perovskite cell, thus constraining the development of the halide perovskite cell.

The bandgap of mixed halide perovskites can be adjusted by changing the halogen ratio, enabling the perovskite cell containing them to have a wide bandgap, high carrier mobility, and long diffusion length. This is conducive to further improving the photoelectric conversion efficiency and stability of the perovskite cell containing them, showing good application prospects.

However, mixed halide perovskite materials not only still have intrinsic uncertainties but also tends to undergo photoinduced phase separation under illumination, leading to severe open-circuit voltage loss and directly affecting the photoelectric conversion efficiency and stability of the mixed halide perovskite cell.

To solve the foregoing problems, the inventors of this application, through extensive scientific experiments, have found that: during the preparation of a mixed halide perovskite light-absorbing layer, the addition of an organic additive with a specific functional group can reduce the intrinsic defects of mixed halide perovskites, suppressing the photoinduced phase separation effect in the mixed halide perovskite light-absorbing layer of the mixed halide perovskite cell, and improving the photoelectric conversion efficiency and stability of mixed halide perovskite cell.

Further, this application provides an organic additive containing a sulfonyl group. With adjustment of the functional group linked to the sulfonyl group, the film quality of the formed mixed halide perovskite light-absorbing layer is adjusted, achieving the improvement on the photoelectric conversion efficiency and stability of the mixed halide perovskite cell.

The technical solutions described in the embodiments of this application are applicable to mixed halide perovskite light-absorbing layers, solar cells, preparation methods thereof, and electric devices. The perovskite cell disclosed in this application can be used for the perovskite tandem solar cell and the silicon-perovskite tandem solar cell, without limitation.

The following further descries this application in details with reference to the accompanying drawings and embodiments.

According to a first aspect, this application provides a precursor for preparing a perovskite light-absorbing layer, including:
a mixed halide perovskite precursor solution and an organic additive added to the mixed halide perovskite precursor solution; where the organic additive includes a sulfonyl group.

In one or more embodiments of this application, the "precursor" refers to an intermediate used to obtain a perovskite light-absorbing layer. The "perovskite light-absorbing layer" is the core component of a perovskite cell and is used to absorb photon energy from sunlight, generate electron-hole pairs, and separate the electron-hole pairs into free electrons and holes under the action of the built-in electric field. The holes are collected by the conductive substrate through the hole transport layer, and the electrons are collected by the metal electrode. The conductive substrate and the metal electrode are connected to form a circuit, thereby generating photocurrent. The "mixed halide perovskite precursor solution" refers to a precursor material used to form a mixed halide perovskite material. The "organic additive" is added to the mixed halide perovskite precursor solution to improve the quality of the formed perovskite light-absorbing layer and suppress the intrinsic defects and photoinduced phase separation of the formed perovskite light-absorbing layer to enhance the photoelectric conversion efficiency and stability of the perovskite cell. The "sulfonyl group" is

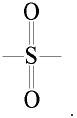

In one or more embodiments of this application, a precursor including the mixed halide perovskite precursor solution and the organic additive is provided, where the organic additive includes a sulfonyl group. Under the condition of preparing a perovskite light-absorbing layer, the crystallization kinetics of mixed halide perovskites in the film formation process is controlled to hinder the mixed halide components from longitudinal gradient phase separation, increasing distribution uniformity of halogen components and reducing the open-circuit voltage loss; and/or reducing photoinduced phase separation of the mixed halide perovskites after illumination and extending the service life of the wide-bandgap perovskite cell.

Specifically, in the organic addition provided in one or more embodiments of this application and including a sulfonyl group, the functional group linked to the sulfonyl group is adjusted so that the organic additive strongly interacts with the mixed halide components in the mixed halide perovskite precursor solution, forming pre-nucleation micelles. This reduces the number of nucleation sites, accelerates nucleation rate, and decreases the crystal growth rate, improving the phase uniformity of the formed perovskite light-absorbing layer, alleviating problems such as intrinsic defects and photoinduced phase separation of the formed perovskite light-absorbing layer, and enhancing the photoelectric conversion efficiency and/or stability of the perovskite cell.

In some embodiments, the organic additive further includes an electron-donating group linked to the sulfonyl group.

In this application, the "electron-donating group" refers to a group with an increased electron cloud density on the benzene ring after a substituent has replaced a hydrogen on the benzene ring.

In one or more embodiments of this application, an electron-donating group is linked to the sulfonyl group. For positive electrical defects in the mixed halide perovskite precursor solution, an organic additive of an electron donor type is introduced to passivate the positive electrical defects in the mixed halide perovskite precursor solution.

In some embodiments, the electron-donating group includes at least one of -F, 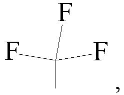 -Cl, -O,

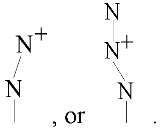

In one or more embodiments of this application, some specific electron-donating groups are provided. When an organic additive containing these groups is added to the mixed halide perovskite precursor solution, the additive strongly interacts with the mixed halide components, showing a good defect passivation effect.

In some embodiments, the sulfonyl group includes at least one of a nitrogen-containing heterocycle, a benzene ring, a carbon chain, or a nitrogen-containing carbon chain. The precursor provided in these embodiments can be arbitrarily combined with the precursor provided in any of the foregoing embodiments.

In one or more embodiments of this application, with the use of an organic additive including at least one of a nitrogen-containing heterocycle, a benzene ring, a carbon chain, or a nitrogen-containing carbon chain, the molecular volume of the organic additive is increased. When the additive strongly interacts with the mixed halide components in the mixed halide perovskite precursor solution, it is conducive to guiding the growth orientation of the perovskite in certain directions, thereby improving the crystallization quality of the perovskite growth and reducing the occurrence of defects.

In some embodiments, the nitrogen-containing heterocycle includes at least one of a nitrogen-containing six-membered heterocycle or a nitrogen-containing five-membered heterocycle.

In one or more embodiments of this application, with the provision of an organic additive including at least one of a nitrogen-containing six-membered heterocycle or a nitrogen-containing five-membered heterocycle, an organic amine-type organic additive is provided. The organic amine strongly interacts with the mixed halide components in the mixed halide perovskite precursor solution, inducing nucleation and growth of iodine-rich phase components, slowing down the crystallization process, and suppressing the formation of grain boundary defects.

In some embodiments, the nitrogen-containing heterocycle includes at least one of

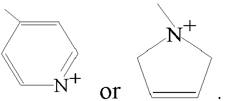

In one or more embodiments of this application, a specific nitrogen-containing heterocycle is provided. In the nitrogen-containing heterocycle, a nitrogen ion is located at the para position relative to a sulfonyl group (-SO₂-) and/or a sulfonyl group (-SO₂-) is linked to a nitrogen ion.

In some embodiments, the carbon chain includes no more than 3 carbon atoms.

In one or more embodiments of this application, a specific carbon chain length is provided. Within this range of carbon chain length, organic additives containing carbon chains can achieve the effect of improving the crystallization quality of perovskite.

In some embodiments, the nitrogen-containing carbon chain includes at least one of

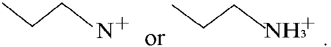

In one or more embodiments of this application, with the provision of a chain-like organic amine-type additive, the improvement on the crystallization quality of perovskite is achieved.

In some embodiments, the organic additive includes at least one of 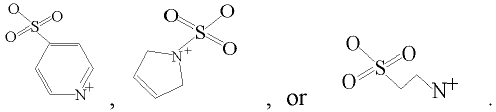 The precursor provided in these embodiments can be arbitrarily combined with the precursor provided in any of the foregoing embodiments.

In one or more embodiments of this application, the functional group linked to the sulfonyl group is adjusted to provide an organic additive containing large volume organic amine cations. This additive coordinates with iodine-rich phase components in the halide components during the preparation of the perovskite light-absorbing layer, inducing nucleation and growth of the iodine-rich phase components, slowing down the crystallization process, suppressing the formation of grain boundary defects, and improving the photoelectric conversion efficiency of the perovskite cell.

In some embodiments, the organic additive includes at least one of 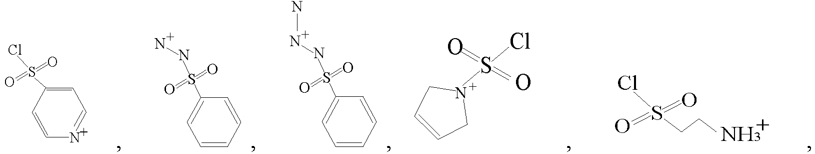 or 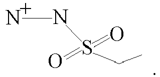 The precursor provided in these embodiments can be arbitrarily combined with the precursor provided in any of the foregoing embodiments.

In one or more embodiments of this application, the functional group linked to the sulfonyl group is adjusted so that the organic additive containing the functional groups coordinate with iodine-rich phase components in the halide components during the preparation of the perovskite light-absorbing layer, inducing nucleation and growth of iodine-rich phase components, slowing down the crystallization process, and suppressing the formation of grain boundary defects. This can suppress the initial photoinduced phase separation of mixed halides to enhance the stability and photoelectric conversion efficiency of the perovskite cell. In one or more embodiments of this application, the formed perovskite light-absorbing layer tends to undergo local component separation after illumination, resulting in reduced stability of the perovskite cell.

In some embodiments, the organic additive includes at least one of 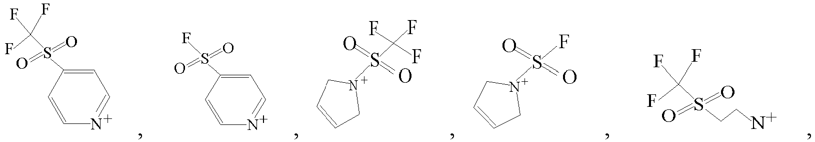 or 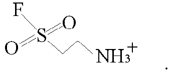 The precursor provided in these embodiments can be arbitrarily combined with the precursor provided in any of the foregoing embodiments.

In one or more embodiments of this application, the functional group linked to the sulfonyl group is adjusted so that the organic additives containing the functional group can strongly interact with halide components during the preparation of the perovskite light-absorbing layer, forming pre-nucleation micelles. This reduces nucleation sites, accelerates nucleation, and decreases crystal growth rate, hindering longitudinal gradient phase separation of halide components to enhance the phase uniformity of the formed perovskite light-absorbing layer, thereby reducing intrinsic defects of mixed halide perovskites and suppressing photoinduced phase separation effects in the perovskite light-absorbing layer of the perovskite cell to enhance the photoelectric conversion efficiency and stability of the perovskite cell and cause no local component separation after illumination, further improving the stability of the perovskite cell.

In some embodiments, a molar amount of the organic additive is 0.1%-10% of a molar amount of the mixed halide perovskite precursor solution. The precursor provided in these embodiments can be arbitrarily combined with the precursor provided in any of the foregoing embodiments.

In one or more embodiments of this application, any proportion of the molar amount of the organic additive that can improve the quality of the formed perovskite light-absorbing layer to the molar amount of the mixed halide perovskite precursor solution is within the protection scope of this application. In one or more embodiments, the molar amount of the organic additive is within the range of 0.1%-10% of the molar amount of the mixed halide perovskite precursor solution, and the quality of the formed perovskite light-absorbing layer is high, effectively hindering interface reactions such as redox between the formed perovskite light-absorbing layer and the carrier transport layer, thereby enhancing the performance of the corresponding perovskite cell.

For example, the molar amount of the organic additive may be 0.1%, 1%, 2%, 5%, or 10% of the molar amount of the mixed halide perovskite precursor solution. It may also be 3%, 4%, 6%, 7%, 8%, or 9%, which is set appropriately as needed.

In some embodiments, the material of the perovskite light-absorbing layer includes:
Cs(_{0-0.0.05})FA_{(0.8-0.95)}MA_{(0-0.10)}PbI_{(2.0-2.7)}Br_{(0.3-1.0}), to provide a specific material for the perovskite light-absorbing layer. The precursor provided in these embodiments can be arbitrarily combined with the precursor provided in any of the foregoing embodiments.

In one or more embodiments of this application, Cs_{(0-0.05})FA_{(0.8-0.95)}MA_{(0-0.10)}PbI_{(2.0-2.7)}Br_{(0.3-1.0)} refers to a specific mixed halide perovskite material, where Cs represents element cesium, FA represents formamidine, MA represents methylamine, Pb represents element lead, I represents element iodine, and Br represents element bromine.

In one or more embodiments of this application, the precursor liquid of Cs_{(0-0.05)}FA_{(0.8-0.95)}MA_{(0-0.10)}PbI_{(2.0-2.7})Br_{(0.3-1.0)} is composed of inorganic cations (Cs⁺, including the case of not adding Cs⁺), formamidine (FA⁺), methylamine (MA⁺), divalent metal cations (Pb2⁺), and halide anions (I⁻, Br⁻).

In one or more embodiments of this application, the provided organic additive is added to the precursor solution of the mixed halide perovskite material so that the organic additive coordinates with the iodine-rich phase components therein, inducing nucleation and growth of iodine-rich phase components, slowing down the crystallization process, suppressing grain boundary defects to enhance the photoelectric conversion efficiency of the perovskite cell, and/or suppressing the initial photoinduced phase separation of mixed halides to enhance the stability of the perovskite cell and/or cause no local component separation after illumination, further improving the stability of the perovskite cell.

According to a second aspect, this application provides a perovskite light-absorbing layer, prepared from any precursor according to the first aspect.

In one or more embodiments of this application, the precursor according to the first aspect is used to prepare a perovskite light-absorbing layer with improved photoelectric conversion efficiency and stability, thereby improving the service life and application prospects of the perovskite cell containing the same.

According to a third aspect, this application provides a preparation method of perovskite light-absorbing layer, including: applying any precursor according to the first aspect to the surface of a buried interface, and performing an annealing treatment on a resulting product to form a perovskite light-absorbing layer.

In one or more embodiments of this application, the "buried interface" refers to a support structure for forming the perovskite light-absorbing layer. In one or more embodiments of this application, the buried interface may be an electron transport layer or a hole transport layer. The "annealing treatment" refers to a heat treatment process where the material is exposed to high temperatures for a period of time and then slowly cooled. In some embodiments, process parameters for the annealing treatment in one or more embodiments of this application are: heat treatment at a temperature of 100°C to 150°C for 10 to 30 minutes.

In one or more embodiments of this application, a preparation method of perovskite light-absorbing layer is provided to form a perovskite light-absorbing layer with good quality and stability from any precursor according to the first aspect.

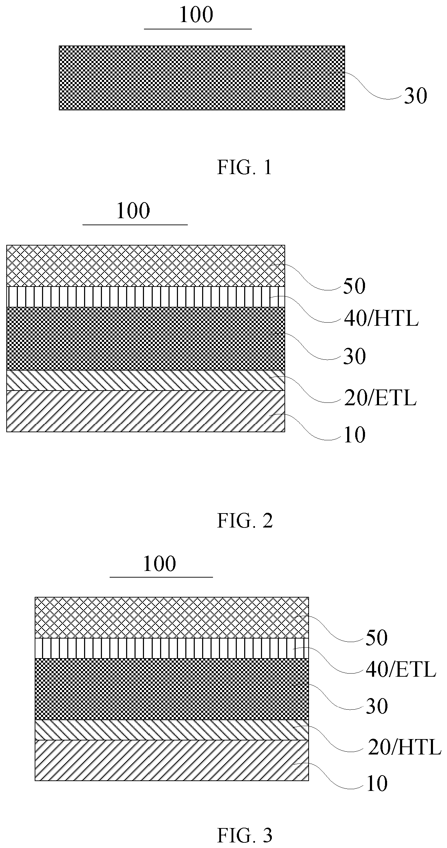

Referring to FIG. 1 to FIG. 3, FIG. 1 is a schematic diagram of a first structure of a perovskite cell according to this application; FIG. 2 is a schematic diagram of a second structure of a perovskite cell according to this application, and FIG. 3 is a schematic diagram of a third structure of a perovskite cell according to this application.

According to a fourth aspect, this application provides a perovskite cell 100. Referring to FIG. 1, the perovskite cell 100 includes a perovskite light-absorbing layer 30; where the perovskite light-absorbing layer 30 includes the perovskite light-absorbing layer 30 according to the second aspect or a perovskite light-absorbing layer 30 prepared by using the method according to the third aspect.

In one or more embodiments of this application, the "perovskite cell 100" refers to a cell that uses a mixed halide-containing perovskite material as the light-absorbing layer material. In this application, mixed halide elements in the "mixed halogen" may be element iodine and element bromine.

In one or more embodiments of this application, the provision of a perovskite cell 100 including the perovskite light-absorbing layer 30 according to the second aspect or a perovskite light-absorbing layer 30 prepared by using the method according to the third aspect is conducive to enhancing the photoelectric conversion efficiency of the perovskite cell 100, and/or suppressing the initial photoinduced phase separation of mixed halides to enhance the stability of the perovskite cell 100 and/or cause no local component separation after illumination, further improving the stability of the perovskite cell 100.

In some embodiments, the perovskite cell 100 includes a conductive substrate 10, a first transport layer 20, the perovskite light-absorbing layer 30, a second transport layer 40, and a metal electrode 50 stacked in sequence. One of the first transport layer 20 and the second transport layer 40 is a hole transport layer HTL, and the other is an electron transport layer ETL.

In one or more embodiments of this application, the "conductive substrate 10" refers to an electrode with high conductivity and high visible light transmittance, used as one output terminal of the perovskite cell 100, such as ITO conductive glass or FTO conductive glass. The "first transport layer 20" and "second transport layer 40" refer to structural layers that transport electrons or holes generated by the perovskite light-absorbing layer 30 under photon excitation. The "hole transport layer HTL," as an important part of the perovskite cell 100, mainly functions to collect and transport holes, achieving effective separation of electrons and holes. The "electron transport layer ETL," also known as electron collection layer, plays an important role in transmitting electrons and blocking electron-hole recombination. The "metal electrode 50" refers to an electrode made of metal, requiring high conductivity and stability as another output terminal of the perovskite cell 100 device.

In one or more embodiments of this application, referring to FIG. 2, when the first transport layer 20 is an electron transport layer ETL and the second transport layer 40 is a hole transport layer HTL, the perovskite cell 100 containing the same is a p-type device.

In one or more embodiments of this application, referring to FIG. 3, when the first transport layer 20 is a hole transport layer HTL and the second transport layer 40 is an electron transport layer ETL, the perovskite cell 100 containing the same is an n-type device.

In one or more embodiments of this application, the provided perovskite cell 100 is suitable for both p-type devices and n-type devices.

In one or more embodiments of this application, the hole transport layer HTL includes at least one of CuSCN, NiOx, CuI, MoOx, WO₃, ZnO, TiO₂, SnO₂, poly(3,4-ethylenedioxythiophene), polystyrene sulfonate, poly[bis(4-phenyl)(2,4,6-trimethylphenyl)amine], 2,2',7,7'-tetrakis[N,N-di(4-methoxyphenyl)amino]-9,9'-spirobifluorene, polyethoxyethyleneimine, polyethyleneimine, or [6,6]-phenyl-C₆₁-butyric acid methyl ester.

In one or more embodiments of this application, the electron transport layer ETL includes at least one of CuSCN, NiOx, CuI, MoOx, WO₃, ZnO, TiO₂, SnO₂, poly(3,4-ethylenedioxythiophene), polystyrene sulfonate, polytriarylamine, 2,2',7,7'-tetrakis[N,N-di(4-methoxyphenyl)amino]-9,9'-spirobifluorene, polyethoxyethyleneimine, polyethyleneimine, [6,6]-phenyl-C₆₁-butyric acid methyl ester, fullerenes, or a hole blocking material.

In one or more embodiments of this application, the hole blocking material is BCP (bathocuproine).

In one or more embodiments of this application, the provision of specific materials for the hole transport layer HTL and the electron transport layer ETL enhances the photoelectric conversion efficiency and stability of the perovskite cell 100.

According to a fifth aspect, this application provides an electric device, including any perovskite cell 100 according to the fourth aspect. The electric device provided in this embodiment can be arbitrarily combined with any perovskite cell 100 provided in any embodiment of the fourth aspect.

In one or more embodiments of this application, the perovskite cell 100 serves as the power source for the electric device described above, or the perovskite cell 100 can be used as an energy storage unit for the electric device described above. For example, the electric device may be a lighting element, a display element, an automobile, or the like.

This application provides organic additives No. 1 to No. 15 for preparing corresponding perovskite cells 100. The chemical structural formulas of organic additives No. 1 to No. 15 are shown in Table 1.

**Table 1: Chemical Structural Formulas of Organic Additives No. 1 to No. 15**

| Item | Chemical structural formula | Item | Chemical structural formula |
|---|---|---|---|
| No. 1 | 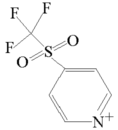 | No. 9 | 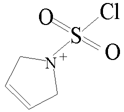 |
| No. 2 | 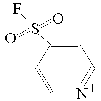 | No. 10 | 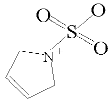 |
| No. 3 | 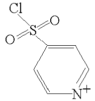 | No. 11 | 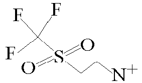 |
| No. 4 | 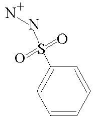 | No. 12 | 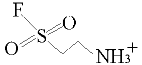 |
| No. 5 | 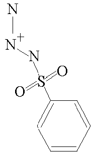 | No. 13 | 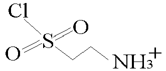 |
| No. 6 | 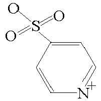 | No. 14 | 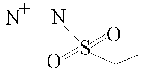 |
| No. 7 | 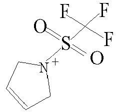 | No. 15 | 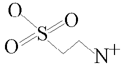 |
| No. 8 | 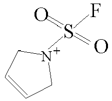 | | |

### Example 1

This example provided a preparation method of perovskite cell 100 as shown in FIG. 3, including the following steps:
(1) cleaning a conductive substrate 10;
(2) forming a nickel oxide layer on a surface of the cleaned conductive substrate 10 to form a hole transport layer HTL as the first transport layer 20, where the thickness of the first transport layer 20 in this example was 30 nm; and a magnetron sputtering method can be used to form the first transport layer 20 on the surface of the cleaned conductive substrate 10;
(3) adding organic additive No. 1 to a mixed halide perovskite precursor solution forming Cs_{0.05}FA_{0.9}MA_{0.05}Pbl_{2.4}Br_{0.6} material, where in this example, a concentration of the mixed halide perovskite precursor solution was 1.3M, a molar amount of No. 1 organic additive was 3% of a molar amount of the mixed halide perovskite precursor solution; the mixed halide perovskite precursor solution with the added organic additive No. 1 was spin-coated on the surface of the first transport layer 20 and subjected to annealing treatment at 120°C for 30 minutes to form a perovskite light-absorbing layer 30 of 450 nm in thickness;
(4) spin-coating PCBM (fullerene) and BCP (bathocuproine, hole blocking material) on the surface of the perovskite light-absorbing layer 30 to form an electron transport layer ETL of 30 nm in thickness as the second transport layer 40; and
(5) thermally evaporating a metal silver electrode of 100 nm in thickness on a surface of the second transport layer 40 away from the conductive substrate 10 to serve as the metal electrode 50.

### Example 2

The preparation method of perovskite cell 100 provided in this example differs from Example 1 in that:

In (3), organic additive No. 2 was used.

The rest were the same as in Example 1.

### Example 3

The preparation method of perovskite cell 100 provided in this example differs from Example 1 in that:

In (3), organic additive No. 3 was used.

The rest were the same as in Example 1.

### Example 4

The preparation method of perovskite cell 100 provided in this example differs from Example 1 in that:

In (3), organic additive No. 4 was used.

The rest were the same as in Example 1.

### Example 5

The preparation method of perovskite cell 100 provided in this example differs from Example 1 in that:

In (3), organic additive No. 5 was used.

The rest were the same as in Example 1.

### Example 6

The preparation method of perovskite cell 100 provided in this example differs from Example 1 in that:

In (3), organic additive No. 6 was used.

The rest were the same as in Example 1.

### Example 7

The preparation method of perovskite cell 100 provided in this example differs from Example 1 in that:

In (3), organic additive No. 7 was used.

The rest were the same as in Example 1.

### Example 8

The preparation method of perovskite cell 100 provided in this example differs from Example 1 in that:

In (3), organic additive No. 8 was used.

The rest were the same as in Example 1.

### Example 9

The preparation method of perovskite cell 100 provided in this example differs from Example 1 in that:

In (3), organic additive No. 9 was used.

The rest were the same as in Example 1.

### Example 10

The preparation method of perovskite cell 100 provided in this example differs from Example 1 in that:

In (3), organic additive No. 10 was used.

The rest were the same as in Example 1.

### Example 11

The preparation method of perovskite cell 100 provided in this example differs from Example 1 in that:

In (3), organic additive No. 11 was used.

The rest were the same as in Example 1.

### Example 12

The preparation method of perovskite solar cell 100 provided in this example differs from Example 1 in that:

In (3), organic additive No. 12 was used.

The rest were the same as in Example 1.

### Example 13

The preparation method of perovskite cell 100 provided in this example differs from Example 1 in that:

In (3), organic additive No. 13 was used.

The rest were the same as in Example 1.

### Example 14

The preparation method of perovskite cell 100 provided in this example differs from Example 1 in that:

In (3), organic additive No. 14 was used.

The rest were the same as in Example 1.

### Example 15

The preparation method of perovskite cell 100 provided in this example differs from Example 1 in that:

In (3), organic additive No. 15 was used.

The rest were the same as in Example 1.

### Comparative example 1

This comparative example provides a preparation method of perovskite cell 100, differing from Example 1 in that:

No organic additive was added in (3).

The rest were the same as in Example 1.

### Experiment example

The photoelectric conversion efficiency and stability of the perovskite cells 100 prepared in Examples 1 to 15 was tested, and test results were shown in Table 2.

In this experiment example, the photoelectric conversion efficiency of the perovskite cells 100 was tested according to IEC61215 standard, and the stability is derived from the rate of change in photoelectric conversion efficiency after 100 hours of aging at 85°C.

**Table 2: Test results of photoelectric performance of the perovskite cells 100 in the examples.**

| Item | Photoelectric conversion efficiency | Rate of change in photoelectric conversion efficiency after 100 hours of aging at 85°C |
|---|---|---|
| Example 1 | 20.34% | -5% |
| Example 2 | 20.16% | -4% |
| Example 3 | 19.26% | -15% |
| Example 4 | 16.38% | -10% |
| Example 5 | 16.2% | -12% |
| Example 6 | 18.36% | -25% |
| Example 7 | 20.34% | -3% |
| Example 8 | 20.16% | -5% |
| Example 9 | 16.38% | -14% |
| Example 10 | 18.54% | -23% |
| Example 11 | 20.34% | -6% |
| Example 12 | 20.52% | -8% |
| Example 13 | 19.44% | -14% |
| Example 14 | 19.26% | -5% |
| Example 15 | 18.36% | -24% |
| Comparative example 1 | 18% | -20% |

According to the test results in Table 2, the following conclusions can be drawn.
(1) From comparisons of the test results of Examples 6, 10, and 15 with the test result of Comparative example1, it can be seen that the photoelectric conversion efficiency of the perovskite cells 100 of the foregoing examples has been somewhat improved compared to that of the comparative examples. This may be attributed to the fact that the addition of organic additives No. 6, No. 10, or No. 15 can improve the crystallization effect of the perovskite light-absorbing layer 30.
(2) From comparisons of the test results of Examples 3, 4, 5, 9, 13, and 14 with the test result of Comparative example 1, it can be seen that the photoelectric conversion efficiency and stability of the perovskite cells 100 of the foregoing examples has been significantly improved compared to that of the comparative example. This may be attributed to the fact that the addition of organic additives No. 3, No. 4, No. 5, No. 9, No. 13, or No. 14 makes their combination effect with the halide-rich phase components in the mixed halide perovskite precursor solution more significant, effectively suppressing the initial photoinduced phase separation of mixed halides and improving the stability of the perovskite cells 100.
(3) From comparisons of the test results of Examples 1, 2, 7, 8, 11, and 12 with the test result of Comparative example 1, it can be seen that the photoelectric conversion efficiency and stability of the perovskite cells 100 of the foregoing examples has been significantly improved compared to that of the comparative example. This may be attributed to the fact that the addition of organic additives No. 1, No. 2, No. 7, No. 8, No. 11, or No. 12 not only has improved the crystallization effect of the perovskite light-absorbing layer 30 and enhanced the quality of the perovskite light-absorbing layer 30, but also has effectively suppressed the initial photoinduced phase separation of mixed halides to enhance the stability of the perovskite cells 100 and cause no local component separation after illumination.

Although this application has been described with reference to the preferred embodiments, various modifications to this application and replacements of the components therein with equivalents can be made without departing from the scope of this application. In particular, as long as there is no structural conflict, the various technical features mentioned in the embodiments can be combined in any manner. This application is not limited to the specific embodiments disclosed in this specification but includes all technical solutions falling within the scope of the claims.

## Claims

1. A precursor for preparing a perovskite light-absorbing layer, comprising:
a mixed halide perovskite precursor solution and an organic additive added to the mixed halide perovskite precursor solution; wherein the organic additive comprises a sulfonyl group.

2. The precursor according to claim 1, wherein the organic additive further comprises an electron-donating group linked to the sulfonyl group.

3. The precursor according to claim 2, wherein the electron-donating group comprises at least one of -F, 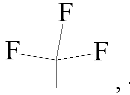 -Cl, -O,

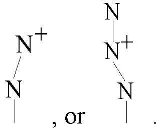

4. The precursor according to any one of claims 1 to 3, wherein the sulfonyl group comprises at least one of a nitrogen-containing heterocycle, a benzene ring, a carbon chain, or a nitrogen-containing carbon chain.

5. The precursor according to claim 4, wherein the nitrogen-containing heterocycle comprises at least one of a nitrogen-containing six-membered heterocycle or a nitrogen-containing five-membered heterocycle.

6. The precursor according to claim 5, wherein the nitrogen-containing heterocycle comprises at least one of

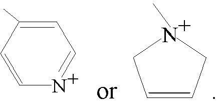

7. The precursor according to claim 4, wherein the carbon chain comprises no more than 3 carbon atoms.

8. The precursor according to claim 4, wherein the nitrogen-containing carbon chain comprises at least one of

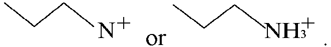

9. The precursor according to any one of claims 1 to 8, wherein the organic additive comprises at least one of

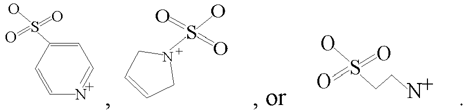

10. The precursor according to any one of claims 1 to 8, wherein the organic additive comprises at least one of

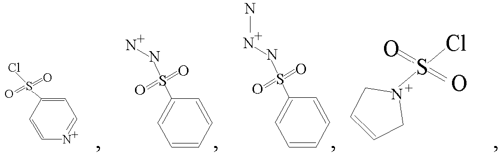

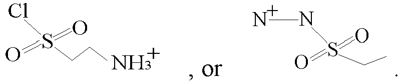

11. The precursor according to any one of claims 1 to 8, wherein the organic additive comprises at least one of

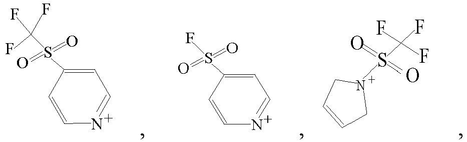

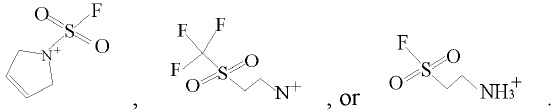

12. The precursor according to any one of claims 1 to 11, wherein a molar amount of the organic additive is 0.1%-10% of a molar amount of the mixed halide perovskite precursor solution.

13. The precursor according to any one of claims 1 to 12, wherein the material of the perovskite light-absorbing layer comprises Cs_{(0-0.05)}FA_{(0.8-0.95)}MA_{(0-0.10})PbI_{(2.0-2.7)}Br_{(0.3-1.0}).

14. A perovskite light-absorbing layer, prepared from the precursor according to any one of claims 1 to 13.

15. A preparation method of perovskite light-absorbing layer, comprising: applying the precursor according to any one of claims 1 to 13 to a surface of a buried interface, and performing an annealing treatment on a resulting product to form a perovskite light-absorbing layer.

16. A perovskite cell, comprising a perovskite light-absorbing layer; wherein the perovskite light-absorbing layer comprises the perovskite light-absorbing layer according to claim 14 or the perovskite light-absorbing layer prepared by using the method according to claim 15.

17. The perovskite cell according to claim 16, wherein the perovskite cell comprises a conductive substrate, a first transport layer, the perovskite light-absorbing layer, a second transport layer, and a metal electrode stacked in sequence; wherein one of the first transport layer and the second transport layer is a hole transport layer, and the other is an electron transport layer.

18. The perovskite cell according to claim 17, wherein the hole transport layer comprises at least one of CuSCN, NiOx, CuI, MoOx, WO₃, ZnO, TiO₂, SnO₂, poly(3,4-ethylenedioxythiophene), polystyrene sulfonate, poly[bis(4-phenyl)(2,4,6-trimethylphenyl)amine], 2,2',7,7'-tetrakis[N,N-di(4-methoxyphenyl)amino]-9,9'-spirobifluorene, polyethoxyethyleneimine, polyethyleneimine, or [6,6]-phenyl-C₆₁-butyric acid methyl ester.

19. The perovskite cell according to claim 17 or 18, wherein the electron transport layer comprises at least one of CuSCN, NiOx, CuI, MoOx, WO₃, ZnO, TiO₂, SnO₂, poly(3,4-ethylenedioxythiophene), polystyrene sulfonate, polytriarylamine, 2,2',7,7'-tetrakis[N,N-di(4-methoxyphenyl)amino]-9,9'-spirobifluorene, polyethoxyethyleneimine, polyethyleneimine, [6,6]-phenyl-C₆₁-butyric acid methyl ester, fullerenes, or a hole blocking material.

20. An electric device, wherein the electric device comprises the perovskite cell according to any one of claims 16 to 19.
